# EUROPEAN PATENT SPECIFICATION

(11) **EP 1 670 976 B1**
(45) Date of publication and mention of the grant of the patent: **15.12.2010**
(21) Application number: 04788859.9
(22) Date of filing: 17.09.2004
(51) Int. Cl.: C30B 29/26, C30B 15/00, C30B 11/00

(54) **SPINEL ARTICLES**
SPINELL-GEGENSTÄNDE
ARTICLES DE SPINELLE

(30) Priority: 23.09.2003 US 669141; 17.03.2004 US 802160
(43) Date of publication of application: 21.06.2006
(73) Proprietor: Saint-Gobain Ceramics and Plastics, Inc., Worcester, MA 01615-0138 (US)
(72) Inventor: KOKTA, Milan, Washougal, WA 98671 (US); STONE-SUNDBERG, Jennifer, Portland, OR 97205 (US); COOKE, Jeffrey, Vancouver, WA 98682 (US); ACKERMAN, Ronald, Vancouver, WA 98682-7332 (US); ONG, Hung, Vancouver, WA 98682 (US); CORRIGAN, Emily, Portland, OR 97220 (US)
(74) Representative: Leidescher, Thomas
(86) International application number: PCT/US2004/030803
(87) International publication number: WO 2005/031047

(56) References cited:
- WO-A2-02/095887
- FR-A- 1 471 976
- US-A- 3 736 158
- US-A- 3 883 313
- US-A- 4 370 739
- US-A1- 2003 188 678
- US-B1- 6 533 874
- WYON C ET AL: "Czochralski growth and optical properties of magnesium-aluminium spinel doped with nickel" JOURNAL OF CRYSTAL GROWTH, NORTH-HOLLAND PUBLISHING CO. AMSTERDAM, NL, vol. 79, no. 1-3, PART 2, 1986, pages 710-713, XP002250057 ISSN: 0022-0248
- GRABMAIER ET AL: "Czochralski growth of magnesium-aluminium spinel" J.AMERICAN CERAMIC SOCIETY, vol. 51, no. 6, 1968, pages 355-356, XP002315185
- PATENT ABSTRACTS OF JAPAN vol. 1999, no. 11, 30 September 1999 (1999-09-30) & JP 11 157997 A (KYOCERA CORP), 15 June 1999 (1999-06-15)

## Description

### TECHNICAL FIELD

The present invention is generally directed to articles having a spinel crystal structure, and includes articles such as boules, wafers, substrates, and active devices incorporating same. In addition, the present invention relates generally to methods for forming such articles. Further, the present invention relates generally to spinel materials particularly useful for optical applications.

### BACKGROUND ART

Active optoelectronic devices, such as light-emitting diodes (LEDs) and laser diodes oftentimes will utilize nitride-based semiconductor layers for the active layer of the device. In this regard, the family of gallium nitride (GaN) materials, which broadly includes Ga(Al, In)N materials, have been utilized as a direct transition-type semiconductor material having a band gap that may be manipulated over a fairly wide range, on the order of about 2 to 6 eV.

In order to take advantage of the optoelectronic characteristics of such nitride-based semiconductor materials, they generally are formed as a single crystal. In this regard, it is generally not pragmatic to form bulk monocrystalline boules of nitride-based semiconductor material. Accordingly, the industry typically has sought to deposit such materials as a monocrystalline layer, such as by epitaxial growth, on an appropriate substrate. It is desired that the substrate on which the nitride-based semiconductor layer is deposited has a compatible crystal structure, to manifest the desired crystal structure in the as-deposited active layer. While such nitride-based materials, such as GaN and AlN can exist in several different crystal states, typically the desired crystal structure is wurtzite rather than zinc blende. In an effort to closely match the desired wurtzite crystal structure, the art has utilized monocrystalline alumina in the form of sapphire (corundum), and specifically oriented the sapphire substrate so as to provide an appropriate crystallographic surface on which the active layer is deposited. However, sapphire suffers from numerous drawbacks. For example, sapphire does not exhibit a cleavage plane that can be used to fabricate active devices. In this regard, it is generally desirable to dice the wafer into individual die (forming active devices, each having a device substrate) by cleavage rather than by slicing or sawing, as cleavage may reduce manufacturing costs and may simplify the manufacturing process.

In contrast, materials having the spinel crystallographic structure, if oriented properly, demonstrate a cleavage plane, the projection of which in the surface of the wafer is generally parallel to a cleavage plane of the nitride active layer, which permits predictable and reliable device fabrication. Despite the technical superiority of spinel over sapphire, a number of processing hurdles exist, resulting in somewhat limited economic feasibility. While the industry has sought to create spinel substrates by a technique known as flame fusion, the so called "Verneuil" technique, such a technique is relatively difficult to carry out, and extremely high processing temperatures have been traced to compositional inhomogeneities in the formed boule.

The industry has also sought to develop single crystalline spinel boules from melt-based process techniques, which include techniques such as the so-called Czochralski technique, among others. In such melt-based techniques, generally a stoichiometric crystal (typically MgO·Al₂O₃, having an MgO:Al₂O₃ ratio of 1: 1) is grown from a batch melt, rather than flame-melted that involves solidification on a solid surface. While melt-based techniques have shown much promise for the creation of single-crystal spinel substrates, the process is relatively difficult to control, and suffers from undesirably low yield rates, increasing costs. In addition, extended cooling periods and annealing periods are carried out to remove residual internal mechanical strain and stress present in the boules following boule formation. Such cooling rates may be unusually low, and cooling periods significantly long, affecting throughput and increasing thermal budget and cost. In a similar manner, the extended annealing times, which may range into the hundreds of hours, further increase processing costs.

Still further, even beyond the relatively high processing costs and despite the precautions taken in an attempt to address residual mechanical strain and stress in the crystal, oftentimes the wafers formed from boules tend to suffer from undesirably high failure rates, with frequently lower than 20% yield rates.

In view of the foregoing, it is generally desirable to provide improved spinel boules, wafers, substrates, and optoelectronic devices incorporating same, as well as improved methods for forming same.

In addition to optoelectronic applications, materials having desirable optical properties are desired. In this regard, various aluminous materials have been used and/or evaluated for demanding optical applications. Such optical applications include, for example, high powered lasing applications, in which the optical material is utilized as a window or mirror, through which an optical laser beam may be passed or reflected. Aluminous materials that have been under consideration include single crystal alumina, typically in the form of sapphire. Other materials are microstructurally distinct from alumina, but containing a substantial portion of alumina groups, including yittria alumina garnet (YAG), as well as spinel (MgO·Al₂O₃). While sapphire and YAG demonstrate certain levels of robustness, the art continually demands materials having superior performance. In addition, sapphire does not have an optically isotropic structure, and accordingly, careful attention must be paid during fabrication of components to properly align the microstructure with the intended axis of the light passing through the component.

Spinel-based materials have shown promise for use in demanding optical applications, such as military use of high powered lasers. However, such materials are not without drawbacks, including material fabrication/processing issues as discussed above.

In view of the foregoing, it is generally desirable to provide improved spinel materials, well suited for optical applications, as well as improved methods for forming same.

### DISCLOSURE OF INVENTION

According to an aspect of the present invention, a single crystal spinel material is provided, the material having a non-stoichiometric composition and having a transparency window represented by absorptivity over a wavelength range, the wavelength range extending from about 400 nm to about 800 nm. The transparency window is defined as the largest single absorptivity peak height along the wavelength range, the largest single peak height being not greater than 0.35 1/cm.

According to an example useful for understanding the present invention, a single crystal spinel boule is formed by melt processing. The boule has a non-stoichiometric composition and has a reduced mechanical stress. The reduced mechanical stress is represented by a relatively high yield rate, generally not less than about 20%. Yield rate is defined by wᵢ/(wᵢ + w_{f}) x 100%, where wᵢ equals the number of intact wafers processed from the boule, and w_{f} equals the number of fractured wafers from the boule due to internal mechanical stress or strain in the boule.

According to another example useful for understanding the present invention, a single crystal spinel wafer is formed by melt processing, the wafer having a non-stoichiometric composition and having a reduced internal stress. The reduced internal stress is represented by a yield rate not less than about 20%. Yield rate is defined as above, namely wᵢ/(wᵢ + w_{f}) x 100%, wherein wᵢ equals the number of intact wafers processed from the boule, and w_{f} equals the number of fractured wafers from the boule due to mechanical stress or strain in the boule.

According to another example useful for understanding the present invention, an optoelectronic substrate is provided, consisting essentially of aMgO·bAl₂O₃ single crystal spinel, wherein a ratio of b:a is greater than 1:1 such that the spinel is rich in Al₂O₃ and the single crystal spinel is formed by a melt process.

According to another example useful for understanding the present invention, a device is provided, which includes a non-stoichiometric spinel substrate formed by melt processing, and an active layer overlying the substrate.

According to another example useful for understanding the present invention, a method for forming single crystal spinel wafers is provided, which includes providing a batch melt in a crucible, growing a spinel single crystal boule from the melt, restricting annealing to a time period not greater than about 50 hours, and slicing the boule into a plurality of wafers.

According to another example useful for understanding the present invention, a method for forming single crystal spinel wafers is provided, including providing a batch melt in a crucible, growing a single crystal spinel boule from the melt, and slicing the boule into a plurality of wafers. In this example, the boule is grown at a process aspect ratio of not less than about 0.39, the process aspect ratio being defined as a ratio of average boule diameter to crucible inside diameter.

According to another example useful for understanding the present invention, a method for forming single crystal spinel wafers is provided, including providing a batch melt in a crucible, growing a spinel single crystal boule from the melt, cooling the boule at a cooling rate not less than about 50°C/hour, and slicing the boule into a plurality of wafers.

According to another example useful for understanding the present invention, a method for forming single crystal spinel wafers is provided, including providing a batch melt in a crucible, growing a spinel single crystal boule from the melt, cooling the boule at a cooling rate not less than about 50°C/hour, restricting annealing to a time period not greater than about 50 hours, and slicing the boule into a plurality of wafers. During the growing step, the boule is grown at a process aspect ratio of not less than about 0.39, wherein process aspect ratio is defined as a ratio of average boule diameter to crucible inside diameter.

### BRIEF DESCRIPTION OF THE DRAWINGS

FIG. 1 is a phase diagram of the MgO-Al₂O₃ system.
FIG. 2 is a photograph of a front view of a small diameter (2-inch) boule grown in a 7-inch diameter crucible. Note : 1 inch = 25.4 mm
FIG. 3 is a photograph of a front view of a large diameter (4-inch) boule grown in a 7-inch diameter crucible.
FIG. 4 is a photograph of a front view of a 2-inch diameter boule grown in a 4-inch diameter crucible.
FIGs. 5 and 6 are front and side views respectively of a mis-oriented (flipped) crystal.
FIGs. 7 and 8 are front and side view photographs of a good [111] crystal.
FIG. 9 illustrates a wafer having a diameter d, and having numerous device substrates or die.
Fig. 10 illustrates an exemplary optoelectronic device FIG. 11 shows a process flow diagram according to an example of the present invention.
FIG. 12 illustrates the optical transmission (absorptivity) properties of a previously developed cobalt-doped inverse spinel used in Q-switching applications.
FIG. 13 illustrates the optical transmission (absorptivity) properties of an alumina rich spinel, according to an embodiment of the present invention.
FIG. 14 illustrates a portion of the curve shown in FIG. 13.

### MODES FOR CARRYING OUT THE INVENTION

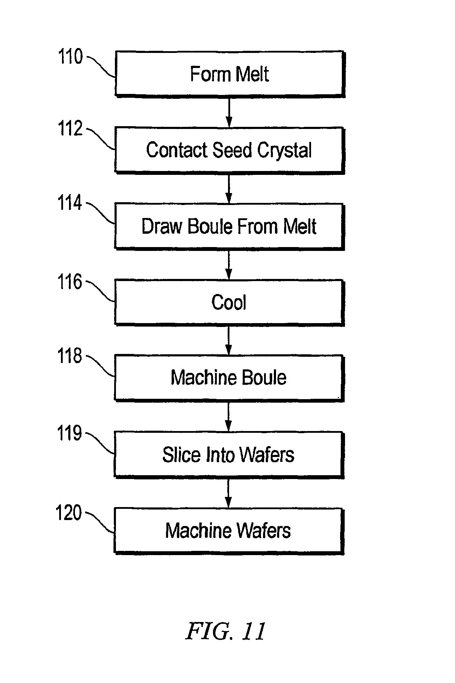

In the present invention, a single crystal spinel boule and single crystal spinel wafers formed therefrom are provided. Typically, processing of a single crystal spinel boule begins with the formation of a batch melt in a crucible, generally illustrated as step 210 in FIG. 11. The batch melt is generally provided to manifest a non-stoichiometric composition in the as-formed boule. The boule has a general formula of aAD·bE₂D₃, wherein A is selected from the group consisting of Mg, Ca, Zn, Mn, Ba, Sr, Cd, Fe, and combinations thereof, E is selected from the group consisting Al, In, Cr, Sc, Lu, Fe, and combinations thereof, and D is selected from the group consisting O, S, Se, and combinations thereof, wherein a ratio b:a > 1:1 such that the spinel is rich in E₂D₃. For clarification, a stoichiometric composition is one in which the ratio of b:a = 1:1, while non-stoichiometric compositions have a b:a ratio ≠ 1:1.

As used herein, the term 'boule' refers to a single crystal mass formed by melt processing, and includes ingots, cylinders, or the like structures.

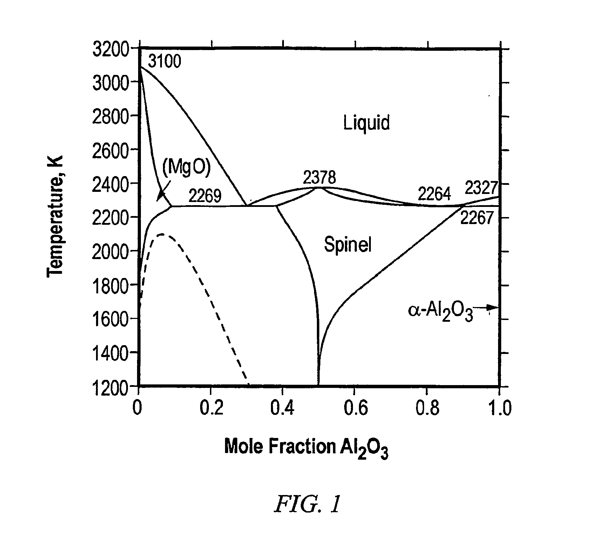

According to certain embodiments, A is Mg, D is O and E is Al, such that the single crystal spinel has the formula aMgO·bAl₂O₃. With respect to the MgO-Al₂O₃ system, attention is drawn to FIG. 1, illustrating a binary phase diagram of MgO-Al₂O₃. As illustrated, as the alumina content of aMgO·bAl₂O₃ increases beyond a ratio of b:a of 1:1 representing the stoichiometric MgO·Al₂O₃ composition, the liquidus temperature decreases. Accordingly, melting may be accomplished at relatively low temperatures. For example, the melt temperature utilized for boule formation in the alumina-rich spinel may be on the order of 50 to 100 degrees lower than the usable melt temperature for stoichiometric spinel. It is noted that stoichiometric spinel having a composition represented by MgO·Al₂O₃ (b:a = 1:1) has a liquidus temperature of about 2378 K, while a ratio of b:a of 4:1 as a liquidus temperature notably lower, about 2264K.

While E₂D₃-rich spinels are generally represented by a ratio b:a greater than 1:1, certain embodiments have a b:a ratio not less than about 1.2:1, such as not less than about 1.5:1. Other embodiments have even higher proportions of E₂D₃ relative to AD, such as not less than about 2.0:1, or even not less than about 2.5:1. According to certain embodiments, the relative content of E₂D₃ is limited, so as to have a b:a ratio not greater than about 4:1. Specific embodiments may have a b:a ratio of about 3:1 (e.g., 2.9:1).

Following formation of a batch melt in a crucible, typically, the spinel single crystal boule is formed by one of various techniques such as the Czochralski pulling technique. While the Czochralski pulling technique has been utilized for formation of certain embodiments herein, it is understood that any one of a number of melt-based techniques, as distinct from flame-fusion techniques, may be utilized. Such melt-based techniques also include the Bridgman method, the liquefied encapsulated Bridgman method, the horizontal gradient freeze method, and edge-defined growth method, the Stockberger method, or the Kryopolus method. These melt-based techniques fundamentally differ from flame fusion techniques in that melt-based techniques grow a boule from a melt. In contrast, flame fusion does not create a batch melt from which a boule is grown, but rather, provides a constant flow of solid raw material (such as in powder form) in a fluid, to a hot flame, and the molten product is then projected against a receiving surface on which the molten product solidifies.

Generally, the single seed crystal is contacted with the melt at step 212 in FIG. 11, while rotating the batch melt and the seed crystal relative to each other. Typically, the seed crystal is formed of stoichiometric spinel and has sufficiently high purity and crystallographic homogeneity to provide a suitable template for boule growth. The seed crystal may be rotated relative to a fixed crucible, the crucible may be rotated relative to a fixed seed crystal, or both the crucible and the seed crystal may be rotated. During rotation, the seed crystal and the actively forming boule are drawn out of the melt in step 214 in FIG. 11.

According to one example useful for understanding the present invention, average boule diameter and interior crucible diameter of the crucible containing the batch melt are controlled to be within certain parameters. Most typically, the single crystal boule is grown at a process aspect ratio of not less than about 0.39. Here, process aspect ratio is defined as a ratio of average boule diameter to crucible diameter. Average boule diameter is the average diameter of the boule along its nominal length, nominal length representing that portion of the boule that is utilized for formation of wafers according to downstream processing steps, generally not including the neck and tail (conical-shaped end caps at opposite ends of the boule). Typically, boule diameter is relatively constant along the nominal length of the boule. Formation at the minimum process aspect ratio helps ensure against unwanted or undesirable crystallographic orientation or re-orientation of the boule, also known as 'flipping'. More specifically, it is desired that the boule have the <111> orientation (triangular morphology), rather than the <110> orientation (square or hexagonal morphology), and sufficiently high aspect ratios may ensure against flipping from the <111> crystallographic orientation to the <110> crystallographic orientation.

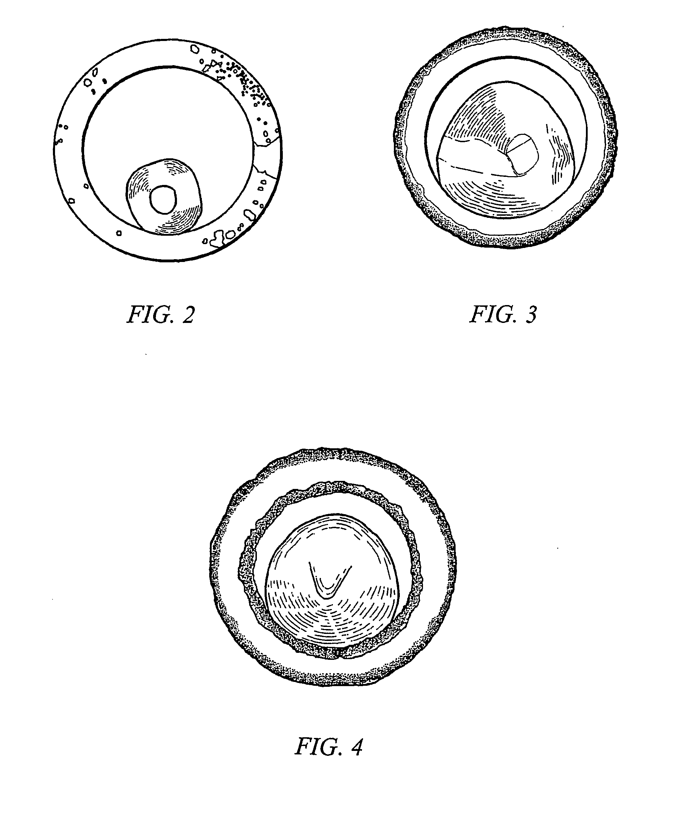

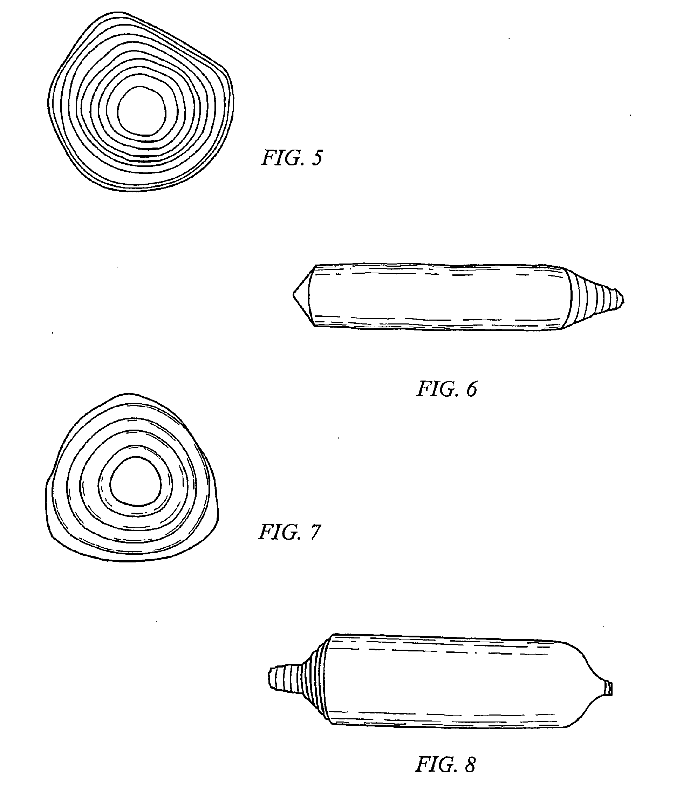

Actual photographs of both desirably oriented <111> boules and "flipped" boules, and the relationship of aspect ratio to crystal orientation, are shown in FIGs. 2-8 and the Table below. FIG. 2 represents a mis-oriented (flipped) single crystal boule formed according to a process aspect ratio of about 0.28 (2 inch boule diameter, 7 inch crucible diameter), while FIGs. 3 and 4 illustrate good <111> single crystal boules formed according to a process aspect ratios of 0.57 (4 inch boule diameter, 7 inch crucible diameter) and 0.50 (2 inch boule diameter, 4 inch crucible diameter). According to examples of the present invention, FIGs. 5 and 6 show end and perspective views of another mis-oriented (flipped) boule while FIGs. 7 and 8 illustrate a good <111> single crystal boule.

With respect to the MgO-Al₂O₃ system, multiple samples were created based upon a 3:1 (2.9:1) b:a ratio, and a summary of the relevant process conditions is provided below in the table. Certain embodiments of the present invention have somewhat higher minimum process aspect ratios, such as not less than about 0.40, not less than about 0.42, or even not less than about 0.43. Other embodiments have even higher process aspect ratios such as not less than about 0.44, or even greater.

**Table**

| Pull rate (mm/hr) | Crucible ID (inches) | Crucible lid ID (inches) | Crystal dia. (inches) | Result, <111> | Aspect Ratio |
|---|---|---|---|---|---|
| 1 | 4 | 2.5 | 2.2 | yes | 0.55 |
| 1 | 5 | 3.5 | 2.2 | no | 0.44 |
| 1 | 6 | 4.5 | 2.2 | no | 0.37 |
| 1 | 7 | 5.25 | 2.2 | no | 0.31 |
| 1 | 7 | 5.25 | 4.1 | yes | 0.59 |
| 1 | 6 | 4.5 | 3.1 | yes | 0.52 |
| 2.5 | 5 | 3.5 | 2.2 | yes | 0.44 |
| 2.5 | 6 | 4.5 | 2.2 | no | 0.37 |
| 2.5 | 7 | 4 | 3.1 | yes | 0.44 |
| 2.5 | 6 | 2.75 | 2.2 | partly | 0.37 |

Typically, the boule consist essentially of a single spinel phase, with no secondary phases. According to another feature, the boule and the wafers processed therefrom are free of impurities and dopants. The wafers can be processed into device substrates for optoelectronic applications, the wafer and substrates having a composition consisting essentially of aMgO·bAl₂O₃, wherein a ratio of b:a is greater than 1:1. In this regard, impurities and dopants are generally precluded. For example, Co is restricted from inclusion in the foregoing example, which otherwise is a dopant for Q-switch applications. In contrast to Q-switch applications, it is generally desired that a relatively pure spinel is utilized substantially free of dopants that affect the basic and novel properties of the device substrates.

According to examples useful for understanding the present invention, a single crystal spinel boule is formed having desirable properties. In addition to the desired <111> orientation described above, the boules, wafers, and device substrates formed therefrom also generally have reduced mechanical stress and/or strain, as compared to a stoichiometric articles having a b:a ratio of 1:1. In this regard, examples of the present invention provide desirably high yield rates in connection with formation of single crystal wafers that form substrates of active devices, and also provide improved processing features, discussed in more detail hereinbelow.

With respect to improved processing features, the boule may be cooled at relatively high cooling rates such as not less than about 50°C/hour, at step 216 in FIG. 11. Even higher cooling rates may be utilized according to examples of the present invention, such as not less than about 100°C/hour, 200°C/hour and even at a rate of greater than about 300°C/hour. The increased cooling rates desirably improve throughput of the fabrication process for forming single crystal boules and further reduce the thermal budget of the entire fabrication, and accordingly reduce costs. Boules formed according to conventional processing generally are cooled at relatively low cooling rates, in an attempt to prevent fracture during the cooling process. However, according to examples of the present invention, the cooling rates may be substantially higher yet still provide intact boules in the as-cooled form. Generally, conventional cooling rates are on the order of 40°C/hour or less, requiring cooling periods on the order of days.

Still further, according to another example of the present invention, annealing of the boule, conventionally carried out subsequent to cooling, is restricted to a relatively short time period. Typically, the time period is not greater than about 50 hours, such as not greater than about 30 hours, or even 20 hours. According to certain examples, the annealing is restricted to a time period not greater than about 10 hours. Indeed, annealing may be substantially completely eliminated (illustrated by lack of an anneal step in FIG. 11), thereby obviating post-forming heat treatment. In contrast, conventional boule forming technology generally requires use of substantial anneal periods in an attempt to mitigate residual internal stress and strain, responsible for low wafer yield rates as well as boule fracture. Without wishing to be tied to any particular theory, it is believed that the reduction and internal stress and strain in the boule according to examples herein permits such flexible processing conditions, including decreased or complete elimination of annealing periods, as well as increased cooling rates as noted above.

According to another feature, the reduction in internal mechanical stress and strain are quantified by yield rate, the number of intact wafers formed by slicing the boule, such as by step 219 in FIG. 11. Typically, slicing is carried out by any one of several slicing techniques, most notably wire sawing. As used herein, yield rate may be quantified by the formula wᵢ/(wᵢ + w_{f}) x 100%, wherein wᵢ = the number of intact wafers processed from the boule, and w_{f} = the number of fractured wafers from the boule due to internal mechanical stress or strain in the boule. Conventionally, this yield rate is very low, such as on the order 10%. The unacceptably low yield rate is a manifestation of excessive internal stresses and strain in the boule. In contrast, yield rates according to examples of the present invention are typically not less than about 25%, 30% or even 40%. Other examples show increasingly high yield rates, such as not less than about 50, 60 or even 70%. Indeed, certain examples have demonstrated near 100% yield. This reduce internal mechanical stress and/or strain as quantified above is not only present within the as-formed (raw) boules, but also the processed boules, the wafers sliced from boules, and the device substrates cleaved from the wafers. In this regard, the foregoing description of processed boules generally denotes boules that have been subjected to post-cooling machining steps as generally denoted by step 218 in FIG. 11, such as grinding, lapping, polishing and cleaning.

Following slicing, the wafers may be further processed such as by machining at step 220 in FIG. 11. The wafers have a generally sufficient diameter and associated surface area to provide reduced processing costs for the active device manufacturer, in a manner similar that increased wafer size reduces semiconductor die cost in the semiconductor fabrication field. Accordingly, it is generally desired that the wafers have a nominal diameter of not less than about 1.75 inches, generally not less than about 2.0 inches and in certain examples, 2.5 inches or greater. Current state-of-the art processing tools for handling wafers in active device fabrication are geared to handle two inch wafers, and processing equipment for handling three inch wafers are presently coming on-line. In this regard, due to processing features and wafer features described herein, next-generation wafers may be supported according to examples of the present invention.

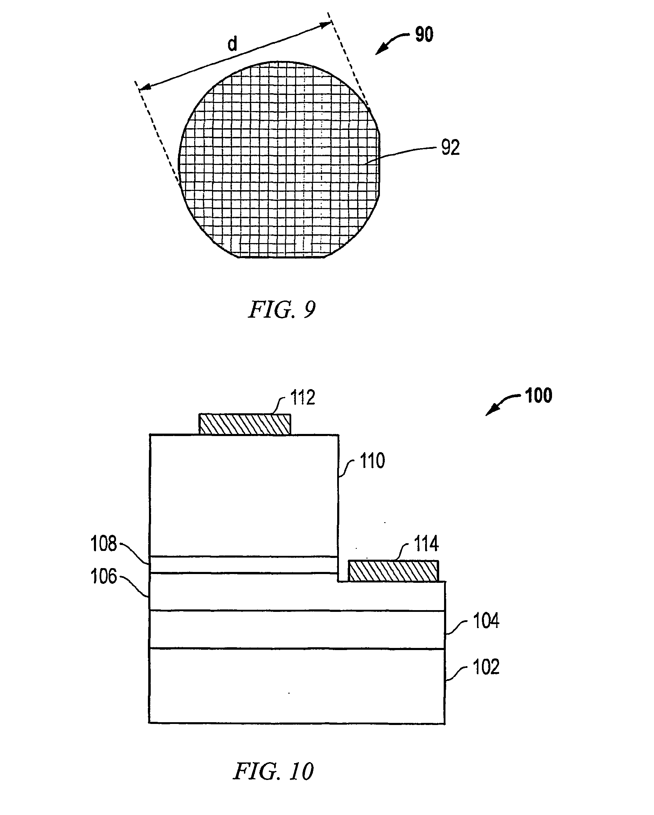

FIG. 9 illustrates a wafer according to an example useful for understanding the present invention, most notably wafer 90 having a plurality of die 92 that form individual device substrates for active devices. As shown, the wafer has a diameter d in accordance with the foregoing description relating to wafer diameter. Typically, the individual device substrates or die 92 are separated from the wafer 90, subsequent to wafer processing, to form individual active devices. In contrast to semiconductor manufacturing in which individual die are typically formed by a sawing operation along kerf lines, the individual active components may be cleaved from the wafer along cleavage planes of the wafer and the overlying active layer, which cleavage planes are generally oriented non-parallel to the plane of the wafer. Generally, the surface of the wafer that is processed has a desirable crystallographic orientation, namely the <111> crystallographic orientation, which is suitable for epitaxial growth of Ga(Al, In)N active materials.

Turning to FIG. 10, an example of an active optoelectronic device is illustrated. The particular optoelectronic device is an LED 100, containing multiple nitride semiconductor layers. LED 100 includes relatively thick n-type GaN HVPE-grown base layer 104 deposited on single crystal spinel device substrate 102 formed according to examples herein. The base layer is overlaid by an n-type GaN layer 106, an intermediate (InGa)N active layer 108, and an upper p-type GaN layer 110. The p-type GaN layer 110 has a p-type contact layer 112 formed thereon, and the lower n-type GaN layer 106 has an n-type contact layer 114 formed along a portion of the device. The n-type GaN layer 106 generally forms the active layer of the device. Additional processing and structural details of active optoelectronic devices such as LEDs are known in the art. The reader is directed to U.S. Patent No. 6,533,874 for additional details related to such devices. While the foregoing example illustrates an LED device, it is understood that the optical, electronic, or optoelectronic active devices may take on various other forms, such as a laser diode.

Turning to optical applications, according to one aspect of the present invention, single crystal spinel materials, generally in the form of structural components, are provided. The single crystal spinel material generally has a non-stoichiometric composition and, according to one embodiment, has a transparency window over a wavelength range. The wavelength range generally extends along a transmission range from about 400 nm to about 800 nm. The transparency window may be defined as the largest single absorptivity peak height along the wavelength range, generally not greater than about 0.35 cm⁻¹. According to certain embodiments, the wavelength range is further extended, meaning that the transparency window is maintained over a wider frequency range. For example, the wavelength range may extend up to about 2000 nm such as 3000 nm, 3500 nm, or even 4000 nm. The above-noted largest single absorptivity peak height in certain examples is even further reduced, representing even superior transmittance properties, such as a height not greater than about 0.33 cm⁻¹, about 0.30 cm⁻¹, about 0.25 cm⁻¹, about 0.20 cm⁻¹, about 0.15 cm⁻¹, or even about 0.10 cm⁻¹. Desirably, transmittance (or absorption) properties are fairly flat over an extended wavelength range, indicating a lack of dependency of transmittance properties based upon wavelength or frequency.

The actual optical transmittance measurements are dependent upon various parameters.. Generally, optical transmittance data are taken from samples having a thickness within a range of about 5 to 10 mm, which samples are machined for parallelism, flatness and surface finish. Samples had a parallelism less than 10 seconds or 0.003 degrees, flatness of 1/10 wave maximum deviation over 90% of aperture as measured with a 632.8nm HeNe, and Mil spec, requiring scratch and dig specifications according to Mil-O-13830A, having a 20/10 finish. However, the reported absorptivity data are intrinsically normalized for thickness of the sample, that is, are generally thickness independent.

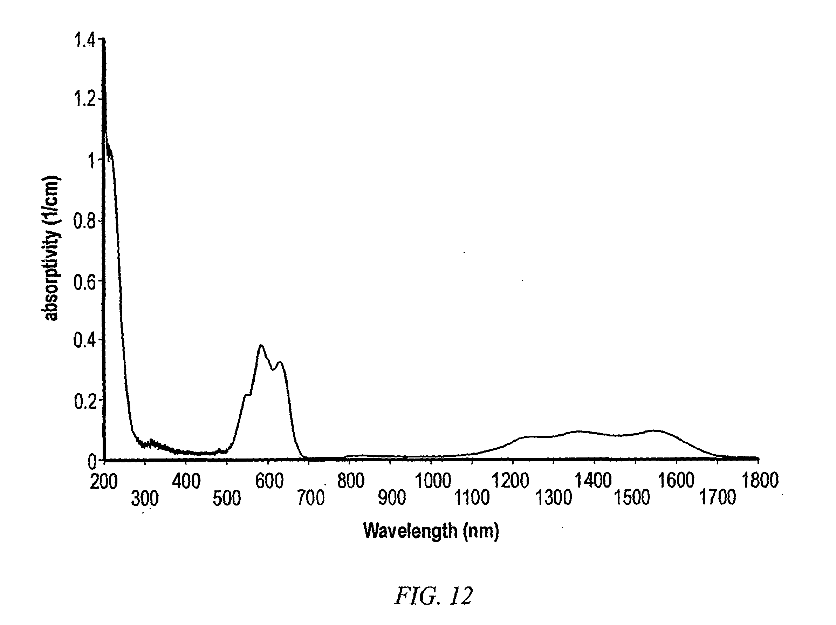

To clarify the foregoing optical properties, attention is drawn to the drawings herein. FIG. 12 illustrates the optical transmission data taken from a MgO·Al₂O₃ spinel having a b:a ratio of 3:1, doped with 0.01% of Co²⁺. This particular material was formed according to an embodiment described in U.S. Patent Application 09/863,013, published as U.S. 2003/0007520, commonly owned by the present assignee. This particular material is used for Q-switching applications, generally distinct from the optical applications according to embodiments of the present invention. As illustrated, the sample has a largest single absorptivity peak height of about 0.4 cm⁻¹ occurring at about 590 nm.

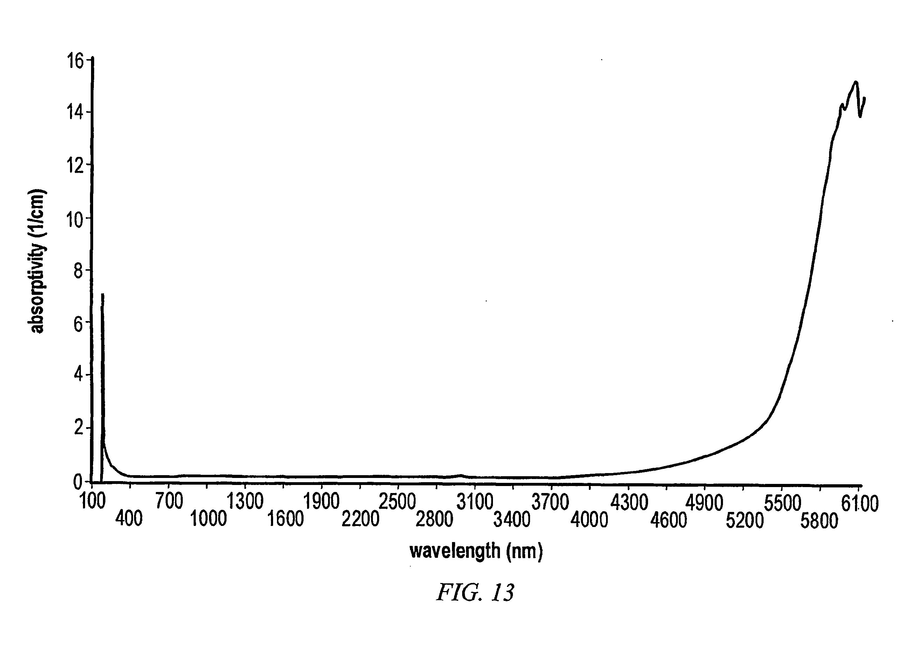

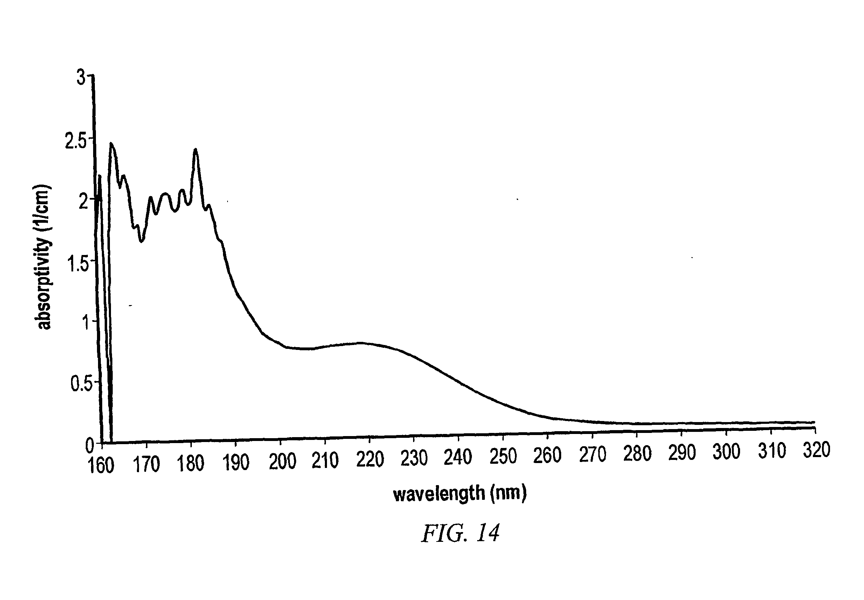

In contrast, FIGS. 13 and 14 illustrate the optical transmission properties according to an embodiment of the present invention, namely an undoped aMgO·bAl₂O₃ spinel having a b:a ratio of about 3:1. As illustrated, the sample has a fairly wide transmission window extending from about 400 nm to about 3700 nm. The largest single absorptivity peak is less than about 0.1 cm⁻¹, occurring at about 800 nm, represents a much smaller optical transmission loss or absorption than the cobalt-doped sample illustrated in FIG. 12. A similar absorptivity peak occurs at about 3000 nm.

Turning to fabrication of spinel materials, typically, processing begins with the formation of a batch melt in a crucible. The batch melt is generally provided to manifest a non-stoichiometric composition in the as-formed spinel material, generally in the form of a "boule," describing a single crystal mass formed by melt processing, which includes ingots, cylinders and the like structures. According to one embodiment, the boule has a general formula of aAD·bE₂D₃, wherein A is selected from the group consisting of Mg, Ca, Zn, Mn, Ba, Sr, Cd, Fe, and combinations thereof, E is selected from the group consisting Al, In, Cr, Sc, Lu, Fe, and combinations thereof, and D is selected from the group consisting O, S, Se, and combinations thereof, wherein a ratio b:a > 1:1 such that the spinel is rich in E₂D₃. For clarification, a stoichiometric composition is one in which the ratio of b:a = 1:1, while non-stoichiometric compositions have a b:a ratio ≠ 1:1.

According to certain embodiments, A is Mg, D is O and E is Al, such that the single crystal spinel has the formula aMgO·bAl₂O₃. While some of the disclosure contained herein makes reference to the MgO-Al₂O₃ spinel based-compositions, it is understood that the present disclosure more generally relates to a broader group of spinel compositions, having the generalized formula aAD·bE₂D_{3,} as described above.

While E₂D₃-rich spinels are generally represented by a ratio b:a greater than 1:1, certain embodiments have a b:a ratio not less than about 1.2:1, such as not less than about 1.5:1. Other embodiments have even higher proportions of E₂D₃ relative to AD, such as not less than about 2.0:1, or even not less than about 2.5:1. According to certain embodiments, the relative content of E₂D₃ is limited, so as to have a b:a ratio not greater than about 4:1. Specific embodiments may have a b:a ratio of about 3:1 (e.g., 2.9:1).

Following formation of a batch melt in a crucible, typically, the spinel single crystal boule is formed by one of various techniques such as the Czochralski pulling technique. While the Czochralski pulling technique has been utilized for formation of certain embodiments herein, it is understood that any one of a number of melt-based techniques, as distinct from flame-fusion techniques, may be utilized. Such melt-based techniques also include the Bridgman method, the liquefied encapsulated Bridgman method, the horizontal gradient freeze method, and edge-defined growth method, the Stockberger method, or the Kryopolus method. These melt-based techniques fundamentally differ from flame fusion techniques in that melt-based techniques grow a boule from a melt. In contrast, flame fusion does not create a batch melt from which a boule is grown, but rather, provides a constant flow of raw material (such as in powder form), to a hot flame, and the molten product is then projected against a receiving surface on which the molten product solidifies.

Generally, the single seed crystal is contacted with the melt, while rotating the batch melt and the seed crystal relative to each other. Typically, the seed crystal is formed of stoichiometric spinel and has sufficiently high purity and crystallographic homogeneity to provide a suitable template for boule growth. The seed crystal may be rotated relative to a fixed crucible, the crucible may be rotated relative to a fixed seed crystal, or both the crucible and the seed crystal may be rotated. During rotation, the seed crystal and the actively forming boule are drawn out of the melt.

Typically, the boule consists essentially of a single spinel phase, with no secondary phases. According to another feature, the boule and the components processed therefrom are free of impurities and dopants. For example, Co is restricted from inclusion in the foregoing embodiment, which otherwise is a dopant for Q-switch applications. In contrast to Q-switch applications, it is generally desired that a relatively pure spinel is utilized substantially free of dopants that affect the basic and novel properties of the device substrates.

According to embodiments of the present invention, a single crystal spinel boule is formed having desirable properties. In addition to desired optical properties, the boules, and components formed therefrom also generally have reduced mechanical stress and/or strain, as compared to stoichiometric articles having a b:a ratio of 1:1. In this regard, embodiments of the present invention provide desirably high yield rates in connection with formation of single crystal components that form integral parts of larger scale optical assemblies, and also provide improved processing features, discussed in more detail hereinbelow.

With respect to improved processing features, the boule may be cooled at relatively high cooling rates such as not less than about 50°C/hour. Even higher cooling rates may be utilized according to embodiments of the present invention, such as not less than about 100°C/hour, 200°C/hour and even at a rate of greater than about 300°C/hour. The increased cooling rates desirably improve throughput of the fabrication process for forming single crystal boules and further reduce the thermal budget of the entire fabrication, and accordingly reduce costs. Boules formed according to conventional processing generally are cooled at relatively low cooling rates, in an attempt to prevent fracture during the cooling process. However, according to embodiments of the present invention, the cooling rates may be substantially higher yet still provide intact boules in the as-cooled form. Generally, conventional cooling rates are on the order of 40°C/hour or less, requiring cooling periods on the order of days.

Still further, according to another embodiment of the present invention, annealing of the boule, conventionally carried out subsequent to cooling, is restricted to a relatively short time period. Typically, the time period is not greater than about 50 hours, such as not greater than about 30 hours, or even 20 hours. According to certain embodiments, the annealing is restricted to a time period not greater than about 10 hours. Indeed, annealing may be substantially completely eliminated, thereby obviating post-forming heat treatment. In contrast, conventional boule forming technology generally requires use of substantial anneal periods in an attempt to mitigate residual internal stress and strain, responsible for low wafer yield rates as well as boule fracture. Without wishing to be tied to any particular theory, it is believed that the reduction and internal stress and strain in the boule according to embodiments herein permits such flexible processing conditions, including decreased or complete elimination of annealing periods, as well as increased cooling rates as noted above.

According to another feature, the reduction in internal mechanical stress and strain are quantified by yield rate, the number of intact components formed by machining the boule. Typically, machining is carried out by any one of several slicing techniques, most notably wire sawing. As used herein, yield rate may be quantified by the formula cᵢ/(cᵢ + c_{f}) x 100%, wherein cᵢ = the number of intact components processed from the boule, and c_{f}= the number of fractured components from the boule due to internal mechanical stress or strain in the boule. Conventionally, this yield rate is very low, such as on the order 10%. The unacceptably low yield rate is a manifestation of excessive internal stresses and strain in the boule. In contrast, yield rates according to embodiments of the present invention are typically not less than about 25%, 30% or even 40%. Other embodiments show increasingly high yield rates, such as not less than about 50, 60 or even 70%. Indeed, certain embodiments have demonstrated near 100% yield. This reduce internal mechanical stress and/or strain as quantified above is not only present within the as-formed (raw) boules, but also the processed boules, the component machined from boules. In this regard, the foregoing description of processed boules generally denotes boules that have been subjected to post-cooling machining steps, such as grinding, lapping, polishing and cleaning.

Turning to the particular physical manifestation of the spinel materials, embodiments may have various geometric configurations. For example, the material may be in the form of a polygonal planar window such as a rectangle or square. Alternatively, the component may be in the shape of a flat disc having a circular or oval outer periphery. Certain specialized applications call for more complex shapes, such as in the form of a cone or dome. Such components may be suitably utilized at the leading end of a laser guided missile, for example. Still other manifestations include light tubes, akin to fiber optic components. A particular application includes mirrors, having a highly polished surface oriented at a particular angle to reflect and/or transmit IR light, in applications such as in lasing devices, particularly including the laser cavity.

Turning to durability testing, various materials were tested in a controlled environment to determine user damage thresholds. Damage testing was carried out by the so-called least fluence failure technique, utilizing a nominal pulse width (FWHM) of 20 ns, at an incidence angle of 0°. The number of sites utilized for testing was varied, generally within a range of 60 to 90. Shots per site were also varied, generally within a range of about 50 to 200. According to an embodiment of the present invention, typically, the material has a laser damage threshold of not less than about 3.00 GW/cm² at a wavelength of 1064 nm. The laser damage threshold may even be higher, such as not less than about 3.25, or even 3.50 GW/cm² at a wavelength of 1064 nm

A first set of data was generated at a wavelength of 1064 nm. The spot diameter (1/e²) was 430 microns. 80 sites were tested at a rate of 200 shots per site. Table 1 below summarizes the data of a 3:1 spinel according to an embodiment of the present invention, as contrasted against stoichimetric 1:1 spinel, as well as sapphire and YAG.

**TABLE 1**

| MATERIAL | Damage Threshold @ 1064 nm (J/cm²) | Damage Threshold @ 1064 nm (GW/cm²) |
|---|---|---|
| Sapphire | 38.6 | 1.93 |
| YAG | 28.0 | 1.40 |
| 1:1 Spinel | 51.7 | 2.58 |
| 3:1 Spinel | 80.0 | 4.00 |

As illustrated, the 3:1 spinel demonstrates superior damage resistance to laser exposure, notably demonstrating an unexpected damage threshold of 4.00 GW/cm².

Table 2 below summarizes the data for various samples at 1540 nm. The testing was carried out in a manner similar to the 1064 nm data. Here, the spot diameter was 115 microns. For the cobalt-doped sample, the spot diameter was 170 microns and 50 shots per site were utilized rather than 200 shots per site.

**TABLE 2**

| MATERIAL | Damage Threshold @ 1540 nm (J/cm²) | Damage Threshold @ 1540 nm (GW/cm²) |
|---|---|---|
| Sapphire | 36.7 | 1.8 |
| YAG | 65.9 | 3.3 |
| 1:1 Spinel | 118.0 | 5.9 |
| 3:1 Spinel | 67.6 | 3.4 |
| 1:3 Spinel Co²⁺ | 63.5 | 3.2 |

Further, damage threshold testing was carried out at a wavelength of 532 nm. Again, testing was carried out in a manner similar to the 1064 nm testing unless otherwise indicated. Here, a spot diameter of 300 microns was utilized, a pulse width of 18 ns and the number of sites was increased to 100, while carrying out 200 shots per site.

**TABLE 3**

| MATERIAL | Damage Threshold @ 532 nm (J/cm²) | Damage Threshold @ 532 nm (GW/cm²) |
|---|---|---|
| Sapphire | 16.38 | 0.82 |
| YAG | 15.61 | 0.78 |
| 1:1 1 Spinel | 44.97 | 2.25 |
| 3:1 Spinel | 10.0 | 0.50 |

Still further, Table 4 below summarizes testing at 2100 nm. Testing was carried out at a pulse width of 40 ns, a spot diameter of 140µm. 50 sites were tested, at a density of 200 shots/site.

**TABLE 4**

| MATERIAL | Damage Threshold @ 2100 nm (J/cm²) | Damage Threshold @ 2100 nm (GW/cm²) |
|---|---|---|
| Sapphire | 35.0 | 1.75 |
| YAG | 53.0 | 2.65 |
| 1:1 Spinel | 60.0 | 3.0 |
| 3:1 Spinel | 50.0 | 2.5 |

Still further, testing was carried out at 3000 nm. Testing was carried out at a pulse width of 10 ns, a spot diameter of 110 µm. 40 sites were tested, at a density of 200 shots/site.

**TABLE 5**

| MATERIAL | Damage Threshold @ 3200 nm (J/cm²) | Damage Threshold @ 3200 nm (GW/cm²) |
|---|---|---|
| Sapphire | 35.0 | 1.75 |
| YAG | 48.8 | 2.44 |
| 1:1 Spinel | >55.0 | >2.75 |
| 3:1 Spinel | >55.0 | >2.75 |

### Example

Crucible Charge Preparation: 392.1 g of MgO were combined with 2876.5g of Al₂O₃ ( aluminum oxide). The raw materials were mixed together and heated for 12 hrs. At 1100 degrees centigrade in ceramic crucible. After cooling, the mixture was transferred into an iridium crucible 100 mm in diameter and 150 mm tall.

Crystal Growth: The iridium crucible with the oxide mixture was placed in standard Czochralski crystal growth station , and heated to the melting point of the oxide mixture by means of radio frequency heating. An inert ambient atmosphere consisting of nitrogen with a small addition of oxygen was used around the crucible.

After the mixture was liquid a small seed crystal of the 1:1 spinel with <111> orientation attached to the pulling rod was used to initiate the start of the crystal growth process. A single crystal boule was grown utilizing the following process conditions, diameter 53 mm, length 150 mm, seed pulling rate 2mm/hr, seed rotation rate 4 rpm, cool-down time 6 hrs, total time 123 hrs.

After cooling the crystal was visually inspected for bubbles, inclusions or any other visible defects. After visual inspection the top and bottom ends were removed, and crystal was subjected to an x-ray orientation check (Laue diffraction technique). After passing all inspection tests the crystal was used for "bar-stock" preparation.

The foregoing description has been presented for purposes of illustration and description. It is not intended to be exhaustive or to limit the scope to the precise form or embodiments disclosed, and modifications and variations are possible in light of the above teachings, or may be acquired from practice of embodiments of the invention.

## Claims

1. A single crystal spinel material, the material having a non-stoichiometric composition and having a transparency window represented by absorptivity over a wavelength range, the wavelength range extending from 400 nm to 800 nm, the transparency window being defined as the largest single absorptivity peak height along said wavelength range, the largest single peak height being not greater than 0.35 cm⁻¹,
wherein the material has the formula aMgO·bAl₂O₃, the material consisting essentially of aMgO·bAl₂O₃, and wherein the ratio b:a is not less than 2.5:1.

2. The material of claim 1, wherein the wavelength range extends up to 2000 nm.

3. The material of claim 1, wherein the wavelength range extends up to 4000 nm.

4. The material of claim 1, wherein the height is not greater than 0.30 cm⁻¹.

5. The material of claim 1, wherein the height is not greater than 0.25 cm⁻¹.

6. The material of claim 1, wherein the material consists essentially of a single spinel phase, with substantially no secondary phases.

7. The material of claim 1, wherein the ratio b:a is 3:1.

8. The material of claim 1, wherein the ratio b:a is not greater than 4:1.

9. The material of claim 1, wherein the material has a lower mechanical stress and strain compared to stoichiometric spinel.

10. The material of claim 1, wherein the material has a laser damage threshold of not less than 3.00 GW/cm², at a wavelength of 1064 nm.

11. The material of claim 1, wherein the material is in the form of an optical window.

12. The material of claim 1, wherein the material is in the form of an optical mirror.

13. The material of claim 1, wherein the material is in the form of a light pipe.

14. The material of claim 1, wherein the material is in the form of a boule.

15. The material of claim 1, wherein the material is in the form of a wafer.

## Patentansprüche

1. Einkristallines Spinellmaterial mit nichtstöchiometrischer Zusammensetzung und einem durch Absorptivität über einen Wellenlängenbereich, der sich von 400 nm bis 800 nm erstreckt, repräsentiertes Transparenzfenster, wobei das Transparenzfenster als die Höhe des größten einzelnen Absorptivitätspeaks über den Wellenbereich definiert ist, wobei die größte Einzelpeakhöhe nicht größer als 0,35 cm⁻¹ ist,
wobei das Material die Formel aMgO·bAl₂O₃ aufweist, wobei das Material im wesentlichen aus aMgO·bAl₂O₃ besteht, und das Verhältnis b:a nicht kleiner als 2,5:1 ist.

2. Material nach Anspruch 1, wobei sich der Wellenlängenbereich bis zu 2000 nm erstreckt.

3. Material nach Anspruch 1, wobei sich der Wellenlängenbereich bis zu 4000 nm erstreckt.

4. Material nach Anspruch 1, wobei die Höhe nicht größer als 0,30 cm⁻¹ ist.

5. Material nach Anspruch 1, wobei die Höhe nicht größer als 0,25 cm⁻¹ ist.

6. Material nach Anspruch 1, wobei das Material im wesentlichen aus einer einzigen Spinellphase weitgehend ohne Sekundärephasen besteht.

7. Material nach Anspruch 1, wobei das Verhältnis b:a 3:1 beträgt.

8. Material nach Anspruch 1, wobei das Verhältnis b:a nicht größer als 4:1 ist.

9. Material nach Anspruch 1, wobei das Material eine niedrigere mechanische Spannung und Verformung aufweist als stöchiometrischer Spinell.

10. Material nach Anspruch 1, wobei das Material einen Laserschädigungsschwellenwert von nicht weniger als 3,00 gW/cm² bei einer Wellenlänge von 1064 nm aufweist.

11. Material nach Anspruch 1, wobei das Material in Form eines optischen Fensters vorliegt.

12. Material nach Anspruch 1, wobei das Material in Form eines optischen Spiegels vorliegt.

13. Material nach Anspruch 1, wobei das Material in Form eines Lichtleiters vorliegt.

14. Material nach Anspruch 1, wobei das Material in Form eines Einkristallkörpers (Boule) vorliegt.

15. Material nach Anspruch 1, wobei das Material in Form eines Wafers vorliegt.

## Revendications

1. Matériau spinelle monocristallin, le matériau ayant une composition non stoechiométrique et présentant une fenêtre de transparence représentée par l'absorptivité sur une certaine gamme de longueurs d'onde, la gamme de longueurs d'onde s'étendant de 400 nm à 800 nm, la fenêtre de transparence étant définie comme la plus grande hauteur de pic d'absorptivité isolé sur ladite gamme de longueurs d'onde, la plus grande hauteur de pic isolé n'étant pas supérieure à 0,35 cm⁻¹,
le matériau ayant pour formule aMgO·bAl₂O₃, le matériau consistant essentiellement en du aMgO·bAl₂O₃, et dans lequel le rapport b:a n'est pas inférieur à 2,5:1.

2. Matériau selon la revendication 1, dans lequel la gamme de longueurs d'onde s'étend jusqu'à 2000 nm.

3. Matériau selon la revendication 1, dans lequel la gamme de longueurs d'onde s'étend jusqu'à 4000 nm.

4. Matériau selon la revendication 1, dans lequel la hauteur n'est pas supérieure à 0,30 cm⁻¹.

5. Matériau selon la revendication 1, dans lequel la hauteur n'est pas supérieure à 0,25 cm⁻¹.

6. Matériau selon la revendication 1, le matériau consistant essentiellement en une seule phase spinelle, avec sensiblement aucune phase secondaire.

7. Matériau selon la revendication 1, dans lequel le rapport b:a vaut 3:1.

8. Matériau selon la revendication 1, dans lequel le rapport b:a n'est pas supérieur à 4:1.

9. Matériau selon la revendication 1, le matériau présentant des contraintes et déformations mécaniques inférieures en comparaison d'un spinelle stoechiométrique.

10. Matériau selon la revendication 1, le matériau présentant un seuil d'endommagement laser supérieur ou égal à 3,00 GW/cm², à une longueur d'onde de 1064 nm.

11. Matériau selon la revendication 1, le matériau se présentant comme une fenêtre optique.

12. Matériau selon la revendication 1, le matériau se présentant comme un miroir optique.

13. Matériau selon la revendication 1, le matériau se présentant comme un conduit de lumière.

14. Matériau selon la revendication 1, le matériau se présentant comme une préforme.

15. Matériau selon la revendication 1, le matériau se présentant comme une tranche.
